(19) Europäisches Patentamt
European Patent Office
Office européen des brevets

(11) **EP 3 763 042 B1**

(12) **EUROPÄISCHE PATENTSCHRIFT**

(45) Veröffentlichungstag und Bekanntmachung des Hinweises auf die Patenterteilung:
**27.09.2023 Patentblatt 2023/39**

(21) Anmeldenummer: **19716096.3**

(22) Anmeldetag: **27.03.2019**

(51) Internationale Patentklassifikation (IPC):
**H03K 17/955** (2006.01)

(52) Gemeinsame Patentklassifikation (CPC):
**H03K 17/955;** H03K 2217/960725

(86) Internationale Anmeldenummer:
**PCT/EP2019/057693**

(87) Internationale Veröffentlichungsnummer:
**WO 2019/233650 (12.12.2019 Gazette 2019/50)**

(54) **VERFAHREN ZUM AUSWERTEN VON KAPAZITÄTSWERTEN EINER KAPAZITIVEN SENSORELEKTRODE UND KAPAZITIVE ANNÄHERUNGSSENSORANORDNUNG**

METHOD FOR EVALUATING CAPACITANCE VALUES OF A CAPACITIVE SENSOR ELECTRODE AND CAPACITIVE PROXIMITY SENSOR ASSEMBLY

PROCÉDÉ D'ÉVALUATION DE VALEURS DE CAPACITÉ D'UNE ÉLECTRODE DE CAPTEUR CAPACITIVE ET ENSEMBLE DE CAPTEUR DE PROXIMITÉ CAPACITIF

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **04.06.2018 DE 102018113267**

(43) Veröffentlichungstag der Anmeldung:
**13.01.2021 Patentblatt 2021/02**

(73) Patentinhaber: **HUF Hülsbeck & Fürst GmbH & Co. KG**
**42551 Velbert (DE)**

(72) Erfinder: **SIEG, Berthold**
**46240 Bottrop (DE)**

(74) Vertreter: **Zenz Patentanwälte Partnerschaft mbB**
**Gutenbergstraße 39**
**45128 Essen (DE)**

(56) Entgegenhaltungen:
DE-A1-102014 007 236     DE-A1-102015 008 485
DE-A1-102016 014 124     US-A1- 2007 089 527

**Beschreibung**

Die Erfindung betrifft ein Verfahren zum Auswerten von Kapazitätswerten einer kapazitiven Sensorelektrode. Die Erfindung betrifft außerdem eine kapazitiven Annäherungssensoranordnung.

Die Verwendung von kapazitiven Sensorelektroden ist aus der Praxis bekannt. Beispiele für Anwendung von kapazitiven Sensorelektroden sind kapazitive Näherungsschalter in Fahrzeugen, mit denen beispielsweise eine Anwesenheit einer Person detektiert wird. Die Funktionalität der mit kapazitiven Sensorelektroden arbeitenden Näherungsschalter beruht auf der Erfassung von kapazitätsabhängigen Eigenschaften der Sensorelektrode zu unterschiedlichen Zeitpunkten. Beispielsweise kann ein bestimmtes Ereignis im Umfeld der Sensorelektrode aus einer Veränderung der Kapazität der Sensorelektrode abgeleitet werden.

Im Zuge der Auswertung der Kapazität zu einem bestimmten Zeitpunkt oder innerhalb eines Zeitfensters wird die kapazitive Sensorelektrode im Allgemeinen mit einem vorgegebenen Potenzial gekoppelt. Die Sensorelektrode bildet dann mit einer Referenzelektrode eine Kapazität. Als Referenzelektrode kann bei dem Beispiel des in einem Fahrzeug vorhandenen Näherungsschalters beispielsweise eine Fahrzeugmasse oder eine Masse des unter dem Fahrzeug befindlichen Bodens dienen. Wenn ein Körperteil eines Bedieners, beispielsweise eine Hand oder ein Fuß, in den sensitiven Bereich der Sensorelektrode eintritt, verändern sich die elektrostatischen Eigenschaften des Gesamtsystems Sensorelektrode-Fahrzeug-Fahrzeugelektronik. Im Rahmen einer Ersatzbetrachtung kann dieser Effekt als Änderung des die Sensorelektrode umhüllenden Dielektrikums angesehen werden.

Um aus dem Kapazitätswert der Sensorelektrode eine Information, beispielsweise über das Vorhandensein einer Hand oder eines Fußes, ableiten zu können, ist die Auswertung des Kapazitätswerts erforderlich.

Für die Auswertung des Kapazitätswerts sind unterschiedliche Vorgehensweisen bekannt. Beispielsweise kann vorgesehen sein, dass ein wiederholtes Aufladen der Sensorelektrode auf ein Referenzpotenzial einer Spannungsquelle und Umladen der Sensorelektrode in eine Speicherkapazität eines Speicherschaltkreises vorgenommen wird und im Anschluss an das wiederholte Auf- und Umladen eine Auswertung der auf der Vergleichskapazität akkumulierten Ladung erfolgt. Ein wiederholtes Auf- und Umladen ist bei einer solchen Vorgehensweise für die Verringerung der Störungsanfälligkeit des Verfahrens vorgesehen. Ein Beispiel für eine Umsetzung dieses Prinzips ist der DE 196 81 725 B4 zu entnehmen.

Eine andere Möglichkeit kann in der Abgabe einer Ladung von einer Speicherkapazität mit bekannter Kapazität auf die Sensorkapazität mit anschließender Messung einer über der Speicherkapazität vorliegenden Spannung sein. Alternativ oder ergänzend kann die Anzahl von erforderlichen Umladungsvorgängen bis zum Überschreiten einer vorgegebenen Grenzspannung gezählt werden. Die Dimensionierung der Kapazitäten zueinander ist für den Fachmann in Abhängigkeit von den gesetzten Rahmenbedingungen problemlos möglich.

Basierend auf einer der vorstehend kurz erläuterten Vorgehensweisen kann die Auswertung des Kapazitätswerts abgeschlossen werden, indem ein von der Kapazität der Sensorelektrode abhängiger Parameter ermittelt wird. Es können unterschiedliche Parameter genutzt werden wie beispielsweise eine Spannung, die über einer Ladung ansammelnden oder abgebenden Kapazität gemessen wird, wie es beispielsweise bei der oben genannten Druckschrift der Fall ist.

Ein anderer zur Auswertung nutzbarer Parameter kann beispielsweise eine Anzahl von Lade- und Entladezyklen bis zum Überschreiten einer Schaltschwelle an einem Kompensationskondensator sein.

Aus der Praxis bekannte Verfahren zur Bestimmung von Kapazitätswerten von Sensorelektroden nutzen das Prinzip, die Sensorelektrode periodisch zu laden und/oder zu entladen, um im Anschluss an das periodische Laden beziehungsweise Entladen einen kapazitätsabhängigen Parameter des Ladevorgangs zu bestimmen. Das periodische Laden und Entladen weist unter anderem den Vorteil auf, dass die maßgeblichen messbaren Eigenschaften der Kapazitäten, beispielweise die über ihnen abfallende Spannung, ein in Abhängigkeit von Zeit oder Zahl der Umladezahl exponentielles Verhalten aufweisen, was eine gute Auswertbarkeit zur Folge hat. Auch kann durch die periodische Wiederholung von Ladevorgängen infolge einer geschickten Einstellung von Lade-/Entladevorgängen und Pausen die Anfälligkeit des Auswerteverfahrens von zufälligen Fluktuationen reduziert werden.

Ein Beispiel für die letztgenannte Vorgehensweise ist der DE 10 2013 112 910 A1 zu entnehmen. Bei dem in der letztgenannten Druckschrift beschriebenen Verfahren wird eine kapazitive Sensorelektrode während einer ersten Auswertungsphase über eine erste Schalteinrichtung mit einer Ladespannung gekoppelt und hierdurch mit Ladung geladen. Zudem wird eine Kompensationskapazität mit einer weiteren, zweiten Schalteinrichtung zwischen einer Referenzspannung und Masse eingekoppelt, wodurch die Kompensationskapazität ebenfalls mit einer Ladung belegt wird. Daran anschließend wird während einer zweiten Auswertungsphase ein Ladungsausgleich zwischen Sensorelektrode und Kompensationskapazität vorgenommen. Die Ermittlung der Elektrodenkapazität erfolgt auf Grundlage einer Auswertung der auf der Kompensationskapazität akkumulierten Ladung.

Ähnliche Vorgehensweisen sind aus DE 10 2014 007236 A1 oder DE 10 2015 008485 A1 bekannt.

Insgesamt ist also festzuhalten, dass aus dem Stand der Technik und aus der Praxis bekannte Verfahren zur Auswertung des Kapazitätswerts einer kapazitiven Sensorelektrode unter anderem das Prinzip nutzen, die Sensorelektrode zyklisch zu laden und/oder zyklisch zu entladen.

Die Erfassung der zur Auswertung genutzten Messwerte, beispielsweise Spannungen über einer Kompensations-, Lade- oder Speicherkapazität, werden gemäß in der Praxis üblicher Vorgehensweise mittels eines Analog-Digital-Wandlers, auch als *analog digital converter,* kurz ADC, als Digitalwert ausgegeben. Der ausgegebene Digitalwert, nachfolgend auch manchmal als ADC-Wert bezeichnet, wird sodann für die weitere Auswertung verwendet. Um bei der Weiterberechnung der erfassten Werte eine möglichst hohe Genauigkeit zu erreichen, ist eine Berücksichtigung von möglichst vielen Bit-Stellen wünschenswert. Ein Nachteil einer Berücksichtigung vieler Bit-Stellen sind die mit zunehmender Bit-Auflösung steigenden Kosten von ADCs.

Vor dem vorstehend erläuterten Hintergrund ist es Aufgabe der Erfindung, eine Möglichkeit bereitzustellen, Kapazitätswerte einer kapazitiven Sensorelektrode bei geringen Kosten, aber dennoch guter Genauigkeit auszuwerten.

Die Aufgabe wird mit einem Verfahren nach Anspruch 1, mit einem Verfahren nach Anspruch 2 und mit einer Annäherungssensoranordnung nach Anspruch 11 gelöst.

Ein Aspekt der Erfindung betrifft ein Verfahren zum Auswerten von Kapazitätswerten einer kapazitiven Sensorelektrode. Der Begriff des Kapazitätswerts ist dabei als ein von der Kapazität der Sensorelektrode abhängiger Wert zu verstehen. Insbesondere kann ein Kapazitätswert als Kapazität oder als Kapazitätsänderung vorgesehen sein sein.

Das Verfahren umfasst die folgenden Schritte:

a) Es wird ein Koppeln der Sensorelektrode mit einem Ladeschaltkreis herbeigeführt. Durch das Koppeln der Sensorelektrode mit dem Ladeschaltkreis wird die Sensorelektrode unter einer vorgegebenen Ladespannung aufgeladen. Die kapazitive Sensorelektrode ist infolge der Kopplung mit dem Ladeschaltkreis mit Ladungsträgern geladen. Die Kopplung erfolgt für einen Zeitraum, der ausreichend ist, um die Sensorelektrode vollständig zu laden, wobei ein vollständiges Laden als ein Ladezustand mit wenigstens 95 Prozent der maximal erreichbaren Ladungsträgerzahl angesehen werden kann, bevorzugt mit wenigstens 99 Prozent. Der Zeitraum der Kopplung beträgt bei in der Automobiltechnik verwendeten Annäherungssensoren typischerweise wenige Mikrosekunden, beispielsweise 1 bis 10 Mikrosekunden. Bevorzugt ist der Zeitraum der Kopplung innerhalb eines Umladungszyklus, besonders bevorzugt während einer gesamten Verfahrensführung, konstant.

b) Nach dem Zeitraum, der für das Aufladen der Sensorelektrode vorgesehen ist, wird ein Entkoppeln der Sensorelektrode von dem Ladeschaltkreis und ein Koppeln der Sensorelektrode mit einem Speicherschaltkreis herbeigeführt. Der Speicherschaltkreis weist eine Speicherkapazität $C_L$ auf, die bevorzugt als Kondensator ausgebildet ist. Selbstverständlich weisen alle sonstigen elektronischen Bauteile, die zwingend zur Umsetzung der Erfindung erforderlich sind (beispielsweise Drähte) ebenfalls eine geringe Kapazität auf, dies ist vom Fachmann bei der Umsetzung zu berücksichtigen wird aber im Rahmen der vorliegenden Beschreibung nicht näher berücksichtigt.

Bevorzugt ist nach dem Koppeln der Sensorelektrode mit dem Speicherschaltkreis die Sensorelektrode in Reihenschaltung mit der Speicherkapazität gekoppelt.

Infolge des Koppelns erfolgt ein Umladen von in der Sensorelektrode gespeicherten Ladungsträgern zu der Speicherkapazität $C_L$ hin. Das Umladen ist ein Ladungsträgerausgleich, der insbesondere in Abhängigkeit der Kapazitäten der Sensorelektrode und der Speicherkapazität erfolgt.

Die Kopplung von Sensorelektrode und Speicherkapazität wird für einen Zeitraum beibehalten, der ausreichend ist, dass sich der Ladungsträgeraustausch vollständig einstellt. Als vollständiger Ladungsträgeraustausch kann beispielsweise ein Umladen von wenigstens 95 Prozent, bevorzugt von wenigstens 99 Prozent, der auf der Sensorelektrode vorhandenen Ladung verstanden werden. Bevorzugt ist der Zeitraum der Kopplung innerhalb eines Umladungszyklus, besonders bevorzugt während einer gesamten Verfahrensführung, konstant.

Nach dem Umladen wird zumindest in Fällen, in denen ein erneutes Koppeln der Sensorelektrode mit dem Ladeschaltkreis vorgesehen ist, ein erneutes Entkoppeln der Sensorelektrode von dem Speicherschaltkreis herbeigeführt, um ein unerwünschtes Aufladen der Speicherkapazität durch die Ladespannung zu verhindern.

Die Schritte a) und b) werden eine vorgegebene Anzahl von Malen $n_{U,i}$ durchgeführt, wobei $n_{U,i}$ eine positive ganze Zahl ist und i ein Laufparameter, der für einen ersten Umladungszyklus 1, für einen zweiten Umladungszyklus 2 beträgt undsoweiter. Durch das wiederholte Durchführen der Schritte a) und b) erfolgt ein sukzessives Aufladen der Speicherkapazität. Nachdem die Schritte a) und b) die vorgegebene Anzahl von Malen durchgeführt wurden, ist mit der alternierenden Durchführung der Schritte a), b), a) b), usw. für insgesamt $n_{U,i}$ Male ein Umladungszyklus beendet.

Es versteht sich, dass für das Ermöglichen eines sukzessiven Aufladens der Speicherkapazität die Speicherkapazität unter Berücksichtigung der Kapazität der Sensorelektrode und unter Berücksichtigung der gewünschten Anzahl von Umladungsvorgängen $n_{U,i}$ innerhalb eines Umladungszyklus dimensioniert sein muss. Beispielsweise kann vorgesehen sein, dass die Speicherkapazität wenigstens dem $n_{U,i}$-fachen der Kapazität der Sensorelektrode entspricht, wobei die Kapazität der Sensorelektrode auch als Sensorkapazität bezeichnet wird. Bevorzugt entspricht die Speicherkapazität genau dem $n_{U,i}$-fachen der Sensorkapazität.

Nachdem ein Umladezyklus beendet ist, erfolgt in einem Schritt c) ein Erfassen eines von der Kapazität der

Sensorelektrode abhängigen Parameters $A_i$ als ADC-Wert. Auch bei dem Parameter $A_i$ bezeichnet i einen Laufindex, der für einen ersten Umladungszyklus 1, für einen zweiten Umladungszyklus 2 beträgt undsoweiter.

Bei dem Parameter $A_i$ kann es sich beispielsweise um eine über der Speicherkapazität anfallende Spannung handeln. Diese ist über die Kondensatorgleichung mit dem, im vorliegenden Fall unveränderlichen und daher bekannten, Wert der Speicherkapazität verknüpft und über die dem Fachmann bekannten Zusammenhänge bei einem Ladungsaustausch zwischen Kondensatoren in einer Schaltung außerdem von der Kapazität der Sensorelektrode abhängig. Über diesen Zusammenhang kann die über der Speicherkapazität anfallende Spannung als Maß für die Kapazität der Sensorelektrode genutzt werden.

Ein wesentlicher Aspekt der Erfindung besteht darin, dass wenigstens zwei Umladungszyklen durchgeführt und jeweils zugehörige Parameter $A_i$ erfasst werden. Es wird also zumindest ein erster Umladungszyklus durchgeführt mit $n_{U,1}$ Umladungsvorgängen und zur Bestimmung eines Parameters $A_1$ und ein zweiter Umladungszyklus durchgeführt mit $n_{U,2}$ Umladungsvorgängen und zur Bestimmung eines Parameters $A_2$.

Mit den Parametern $A_1$ aus dem ersten Umladungszyklus und $A_2$ aus dem zweiten Umladungszyklus wird ein Gesamtwert $A_{ges}$ gebildet. Dies erfolgt durch mathematische Operationen, die beispielsweise schaltungstechnisch umgesetzt sein können. Beispielsweise kann der Gesamtwert $A_{ges}$ die Summe der Parameter $A_1$ und $A_2$ umfassen oder die Summe der Parameter $A_1$ und $A_2$ sein.

Ein weiterer wesentlicher Aspekt der Erfindung besteht darin, dass die Anzahl $n_{U,i}$ zwischen dem ersten Umladungszyklus und dem zweiten Umladungszyklus um wenigstens die Anzahl 1, in einem bevorzugten Spezialfall um genau 1, voneinander abweichen.

Abschließend wird der Kapazitätswert der Sensorelektrode unter Nutzung des Gesamtwerts $A_{ges}$ ausgewertet. Das Auswerten des Kapazitätswerts der Sensorelektrode kann beispielsweise das Vergleichen eines von der Kapazität der Sensorelektrode abhängigen Werts mit einem Sollwert und/oder das Berechnen der Kapazität der Sensorelektrode sein. Wenn beispielsweise $A_1$ und $A_2$ jeweils an der Speicherkapazität abgegriffene Spannungswerte sind, ist $A_{ges}$ von der Kapazität der Sensorelektrode abhängig und das Auswerten des Kapazitätswerts der Sensorelektrode kann in einem Vergleichen von $A_{ges}$ mit einem Referenzwert bestehen.

Bevorzugt sind alle Umladungsvorgänge, das heißt alle Schrittpaare a) und b), innerhalb eines Umladungsyklus, bevorzugt für alle Umladungszyklen, gleichlang dauernd und äquidistant. Dadurch sind beispielsweise zwischen zwei aufeinanderfolgenden Schritten a) und aufeinanderfolgenden Schritten b) stets die gleichen Zeitabstände vorgesehen.

Erfindungsgemäß sind $n_{U,i}$ und $n_{U,i+1}$ für zumindest ein i, also wenigstens zwei Umladungszyklen, derart vorgegeben und auf den Arbeitspunkt zur Erfassung der Parameter $A_i$ und $A_{i+1}$ angepasst, dass bei unveränderter Kapazität der Sensorelektrode ein Summenwert, bevorzugt die Summe, aus $A_i$ und $A_{i+1}$ und/oder ein Differenzwert, bevorzugt die Differenz, aus $A_i$ und $A_{i+1}$ am Arbeitspunkt genau zwischen zwei Bits einer ADC-Ausgabe liegt oder von diesem "Mittelwert" um höchstens einen tolerierten Maximalwert abweicht. Mit anderen Worten erfolgt die Abstimmung erfindungsgemäß so, dass der Summenwert oder der Differenzwert von $A_i$ und $A_{i+1}$ in Dezimaldarstellung genau zwischen zwei ganzzahligen Werten liegt oder maximal einen tolerierten Maximalwert von der Mitte zwischen den ganzzahligen Werten liegt. Beispielsweise kann im Falle von zwei Umladungszyklen vorgesehen sein, dass $n_{U,1}$ und $n_{U,2}$ und der Arbeitspunkt zur Erfassung von A1 und A2 derart aufeinander angepasst sind, dass der Absolutbetrag der Differenz A1-A2 als erste Nachkommastelle eine 5 und als zweite Nachkommstelle eine Null aufweisen würde, wenn denn der ADC in der Lage wäre einen solchen nichtganzzahligen Wert im Dezimalsystem zu erfassen. Als Arbeitspunkt im ersten Umladungszyklus kann beispielsweise eine Anzahl von Umladungsvorgängen $n_{U,1}$ vorgesehen sein, in der ein (1-1/e)-tel der Speicherkapazität $C_L$ aufgeladen ist, also bei einem einfachen der sogenannten Zeitkonstante der Speicherkapazität. Als Arbeitspunkt im zweiten Umladungszyklus kann beispielsweise vorgesehen sein, dass ein Umladungsvorgang weniger als im ersten Umladungszyklus vorgenommen wird, also $n_{U,2} = n_{U,1} - 1$. Dadurch, dass $A_1$-$A_2$ einen Wert genau, oder im Rahmen der Toleranz genau angesehen, zwischen zwei ganzzahligen der insgesamt 2^(Bitzahl) ADC-Werten aufweist, wird im Ergebnis erreicht, dass die Differenz oder die Summe aus $A_1$ und $A_2$ oder ein aus diesen abgeleiteter Wert einen Nachbarbit der Ausgabe des ADC-Wandlers einnehmen (der bei 10 Bit beispielsweise 1024 Werte einnehmen kann) bei einer minimal möglichen oder nahezu minimal möglichen Änderung der Kapazität der Sensorelektrode.

Mit anderen Worten ausgedrückt, wird die Anzahl der Umladungsvorgänge bei einem ersten Umladungszyklus und die sich von dieser um wenigstens 1 unterscheidende Anzahl der Umladungsvorgänge bei einem zweiten Umladungszyklus derart auf den Arbeitspunkt zur Erfassung der Parameter $A_1$ und $A_2$ angepasst, dass bei unveränderter Kapazität der Sensorelektrode zwischen dem ersten Umladungszyklus und dem zweiten Umladungszyklus die Veränderung des ADC-Werts von $A_1$ zu dem ADC-Wert von $A_2$ derart ist, dass entweder die Summe oder die Differenz von $A_2$ und $A_1$ genau in der Mitte zwischen zwei Bits in der Auflösung des verwendeten ADC-Wandlers liegt oder alternativ von der Mitte zwischen zwei Bits höchstens eine Maximalabweichung entfernt liegt. Dadurch wird der Vorteil erreicht, dass bei Verwendung einer Summe beziehungsweise Differenz (je nach Fall) im Zuge der Auswertung des Kapazitätswerts eine Veränderung der Kapazität der Sensorelektrode nur noch in einer Höhe erforderlich ist, die eine Veränderung der Summe oder der Differenz von $A_2$ und $A_1$ herbeiführen, die der Hälfte der durch ein Bit auflösbaren Werte von $A_i$ entsprechen. Mit anderen Worten wird die Auflösung der Sensorempfindlichkeit in etwa verdoppelt. In dem oben auch genannten alternativen Fall, dass eine Abweichung um einen tolerierten Maximalwert von der Mitte zwischen den ganzzahligen Werten vorgesehen ist, ist der Auflösungsgewinn entsprechend geringfügig geringer. Die genaue Anpassung kann durch den die Erfindung umsetzenden Fachmann vorgenommen werden unter Berücksichtigung der angestrebten Auflösung einerseits und der gewünschten Robustheit des Verfahrens, beispielsweise hinsichtlich Reproduzierbarkeit, andererseits. Das Verfahren weist den besonderen Vorteil auf, dass bei gleichbleibender erforderlicher Hardwareausstattung eine verbesserte Auflösung erreicht wird.

Das oben gesagte kann in einem Spezialfall damit ausgedrückt werden, dass $n_{U,i}$ derart gewählt werden, dass für den ersten Umladungszyklus und den zweiten Umladungszyklus eine Abweichung

$$\mathrm{Abs}(A_2{}^{dez}-A_1{}^{dez})-0,5-D \;<\; \mathrm{Abw}_{tol}$$

mit einer tolerierten Maximalabweichung $\mathrm{Abw}_{tol}$ ist, wobei D ein ganzzahliger ADC-Offset ist, Abs den Absolutbetrag bildet und der Index "dez" den Dezimalwert bei unendlich hoher Auflösung bezeichnet. Bevorzugt ist die tolerierte Maximalabweichung (im Dezimalsystem) $\mathrm{Abw}_{tol}$ höchstens 0,10 Promille, besonders bevorzugt höchstens 0,05 Promille, des Maximalwerts des ADC-Wandlers, also bei einem 10-Bit-Wandler 0,10 Promille von 1024 beziehungsweise 0,05 Promille von 1024.

Mittels einer Berechnung der obigen Abweichungsbedingung ergibt sich bei Berücksichtigung von $n_{U,i} < 100$ für das vorliegende Verfahren bei Verwendung eines 10-Bit-ADC-Wandlers und für die Bedingungen $C_L = n_{U,i} \times$ (Kapazität der Sensorelektrode) sowie $n_{U,i+1} = N-1$ eine bevorzugte Zahl von Umladungszyklen $n_{U,i} = N$ mit N = 22, N = 40, N = 58, N = 69 oder N = 84. Selbstverständlich würden andere Kapazitäten und anders gewählte Arbeitspunkte zu anderen Ergebnissen führen, die Ergebnisse belegen aber, dass mit einer technisch sinnvoll umsetzbaren Anzahl von Umladungsvorgängen mehrere Optionen für die Umsetzung des Verfahrens gefunden werden können.

Für die entsprechende Auswahl von der Anzahl von Umladungsvorgängen in einander nachfolgenden Umladungszyklen zur Herbeiführung einer Summe oder Differenz der erfassten Parameter $A_1$ und $A_2$ mit einem genau oder innerhalb einer tolerierten Maximalabweichung liegenden Wert gibt es bereits aufgrund der Freiheit in der Wahl des Arbeitspunkts sowie der Zahl der sonstigen beteiligten Parameter, beispielsweise der Kapazitäten, viele Möglichkeiten. Für den Fachmann ist es aber immer möglich, geeignete Werte zu ermitteln, beispielsweise empirisch oder durch Simulation.

In einer Weiterbildung des Verfahrens ist vorgesehen, dass eine Folge von Umladungszyklen durchgeführt wird, wobei $n_{U,i} = N$ und $n_{U,i} = N-1$ bei allen unmittelbar aufeinander nachfolgenden Umladungszyklen alternieren, dass also $n_{U,1} = N$, $n_{U,2} = N-1$, $n_{U,3} = N$, $n_{U,4} = N-1$ usw. sind. Dadurch, für einzelne Umladungszyklen des Verfahrens voneinander minimal abweichende Umladungszahlen genutzt werden, werden Artefakte, beispielsweise durch zeitabhängige Effekte in der schaltungstechnischen Umsetzung, vermieden und wird durch Erreichen ähnlicher Werte in Zeit und in $A_i$ stets in einem vergleichbaren Empfindlichkeitsbereich gearbeitet.

Gemäß einer Variante wird

$A_{ges}$ mit $A_1 - A_2 + C$ ermittelt, mit C als positiver oder negativer ganzer Zahl oder Null, zur Bereitstellung von $A_{ges}$ als ADC-Werte mit um gegenüber $A_1$, $A_2$ um einen Bit erhöhter Auflösung. Besonders bevorzugt gilt dies für alle unmittelbar aufeinander folgende Werte.

Bevorzugt werden $A_i$ als 10-Bit-ADC-Werte erfasst, wodurch einerseits die Nutzung vergleichsweise preisgünstiger Hardware erlaubt wird und andererseits eine ausreichend gute Genauigkeit erreicht wird.

Ein weiterer Gedanke der Erfindung betrifft eine Umsetzung des oben beschriebenen Verfahrens in analoger Weise mit einer Auswertung eines Entladens der Speicherkapazität anstatt eines Ladens der Speicherkapazität. Das Verfahren weist die folgenden Schritte auf:

a) Koppeln einer Speicherkapazität $C_L$ eines Speicherschaltkreises mit einem Ladeschaltkreis zum Aufladen der Speicherkapazität mit Ladungsträgern unter einer vorgegebenen Ladespannung, nachfolgend Entkoppeln der Speicherkapazität von dem Ladeschaltkreis,
b) Koppeln des Speicherschaltkreises mit der Sensorelektrode, zum Umladen von in der Speicherkapazität gespeicherten Ladungsträgern zu der Sensorelektrode hin,
c) Entkoppeln der Sensorelektrode von dem Speicherschaltkreis und Entladen der Sensorelektrode,
wobei Schritte b) und c) innerhalb eines Umladungszyklus eine vorgegebene Anzahl von Malen $n_{U,i}$ durchgeführt werden zum sukzessive Entladen der Speicherkapazität,
d) Erfassen eines von der Kapazität der Sensorelektrode abhängigen Parameters $A_i$ als ADC-Wert nach Abschluss des Umladungszyklus,

wobei wenigstens zwei Umladungszyklen durchgeführt und jeweils zugehörige Parameter $A_i$ erfasst werden.

Analog zu der oben beschriebenen Vorgehensweise wird ein Gesamtwert $A_{ges}$ aus Parametern $A_1$ aus einem ersten Umladungszyklus und $A_2$ aus einem zweiten Umladungszyklus gebildet, wobei die Anzahl $n_{U,i}$ zwischen dem ersten Umladungszyklus und dem zweiten Umladungszyklus um wenigstens die Anzahl 1 voneinander abweichen. Der Kapazitätswert der Sensorelektrode wird unter Nutzung des Gesamtwerts $A_{ges}$ ausgewertet.

Die vorstehend genannte wie die eingangs erläuterte Verfahrensführung sind alternierend nutzbar für eine Verbesserung der Genauigkeit der Auswertung. Alle Weiterbildungen und Varianten des eingangs beschriebenen ersten Verfahrens sind auch mit dem vorstehend beschriebenen zweiten Verfahren in gleicher Weise nutzbar. Als ein Unterschied ist selbstverständlich die erfassbare Spannung am Arbeitspunkt, wenn dieser als einfache Zeitkonstante gewählt wird, geringer, nämlich 1/e-tel.

Ein weiterer Gedanke der Erfindung betrifft eine kapazitive Annäherungssensoranordnung mit

- einer Sensorelektrode,
- einem Ladeschaltkreis, der mittels eines ersten Schalters mit der Sensorelektrode koppelbar und entkoppelbar ist,
- einem Speicherschaltkreis, der eine Speicherkapazität $C_L$ aufweist und mittels eines zweiten Schalters mit der Sensorelektrode koppelbar und entkoppelbar ist,
- einen Analog-Digital-Umsetzer, kurz: ADC-Wandler,
- und einem Mikrocontroller.

Der Mikrocontroller ist eingerichtet, den ersten Schalter und den zweiten Schalter gemäß einem Verfahren nach einem der vorhergehenden Ansprüche anzusteuern.

Besonders bevorzugt ist die Verwendung eines der beschriebenen Verfahren zur Auswertung einer Kapazität oder Kapazitätsänderung eines Annäherungsschalters eines Kraftfahrzeugs.

Weitere Einzelheiten, Merkmale und Vorteile des Gegenstands der Erfindung ergeben sich aus der nachfolgenden Beschreibung in Zusammenhang mit den Zeichnungen, in denen beispielhaft Ausführungsbeispiele dargestellt sind.

Es zeigen:

Fig. 1a) bis 1b): Eine schematische Prinzipdarstellung eines Beispiels für eine Anordnung von Sensorelektrode und Speicherkapazität in einem Auswerteschaltkreis;

Figs. 2a) bis 2b): Schematische Darstellung von bei während zwei unmittelbar aufeinander folgender Entlade- und Ladezyklen an einer Sensorelektrode anfallender Spannung zur Erläuterung des Vorgehens bei Durchführung des erfindungsgemäßen Verfahrens.

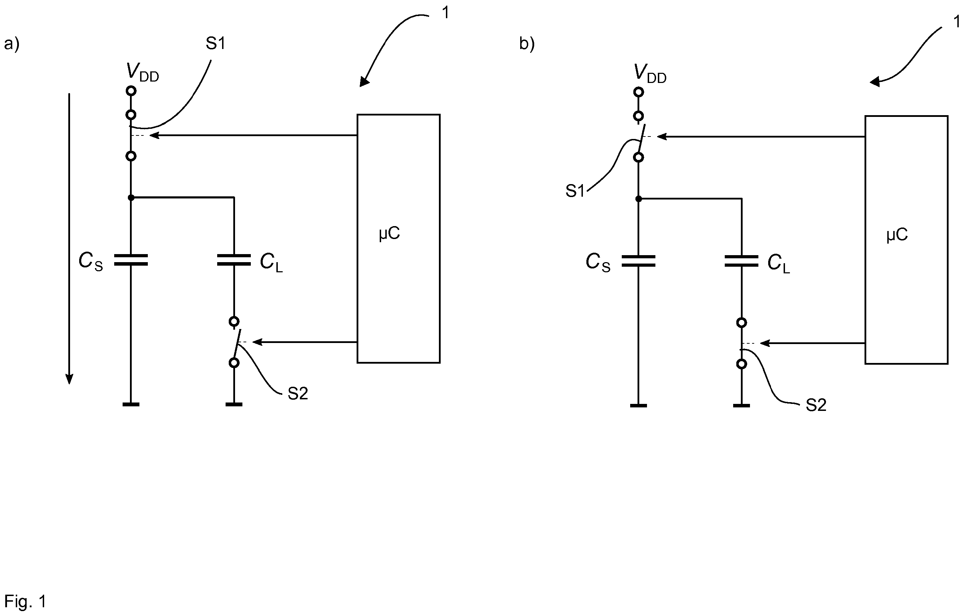

Fig. 1 ist eine beispielhafte Ausgestaltung einer kapazitiven Annäherungssensoranordnung und deren Verhalten zur erfindungsgemäßen Verfahrensführung zu entnehmen.

Die Annäherungssensoranordnung 1 weist eine Sensorelektrode auf, die durch die Kapazität $C_S$ symbolisiert ist. Die Sensorelektrode ist in Fig. 1a) mit einem Ladeschaltkreis gekoppelt zur Spannungsversorgung mit $V_{DD}$. Andererseits ist eine Reihenschaltung von $C_S$ mit einem Speicherschaltkreis möglich, der die Speicherkapazität $C_L$ aufweist.

Die Schalter $S_1$ und $S_2$ sind über einen Mikrocontroller $\mu C$ ansteuerbar. Zur Durchführung eines Umladungsvorgangs wird in einem ersten, in Fig. 1a) dargestellten, Schritt die Sensorelektrode $C_S$ mit dem Ladeschaltkreis gekoppelt zum Aufladen der Sensorelektrode unter der Ladespannung $V_{DD}$. Hiernach erfolgt ein Öffnen von S1 und ein Schließen von $S_2$ (in dieser Reihenfolge) zum elektrisch wirksamen Koppeln von $C_S$ mit $C_L$ zu einer Reihenschaltung von Kapazitäten. In der Folge erfolgt ein Ladungsträgerausgleich zwischen $C_S$ und $C_L$. Diese Vorgehensweise wird sooft wiederholt, bis die vorgegebene Anzahl von Umladungsvorgängen $n_{U,i}$ erreicht ist und die Speicherkapazität sukzessive aufgeladen ist bis zum gewünschten Arbeitspunkt. Damit ist ein Umladungszyklus beendet.

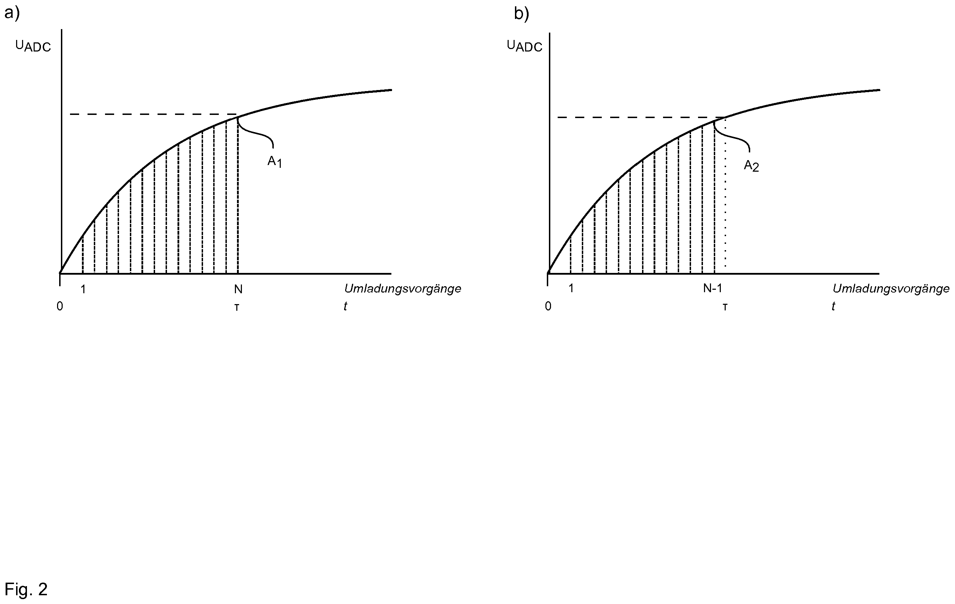

Die Vorgehensweise, welche der erfindungsgemäßen Verfahrensführung zugrunde liegt, ist den Figs. 2a und 2b zu entnehmen. Fig. 2a ist eine Kurve zu entnehmen, welche den Verlauf einer ADC-Spannung $U_{ADC}$ über dem Ladekondensator, welcher die Speicherkapazität bildet, während eines erfindungsgemäßen wiederholten Entladens der Sensorelektrode und pulsweisen Aufladens der Speicherkapazität beschreibt. Der Verlauf nähert sich mit jedem weiteren Umladungsvorgang in exponentieller Annäherung dem für den Ladekondensator möglichen Maximalwert. Die Spannung steigt mit jedem Umladungsvorgang an und erreicht an dem Arbeitspunkt, der Zeitkonstante von $C_L$ entsprechend, nach N Umladungsvorgängen eine Spannung, die als Parameter $A_1$ als ADC-Wert zur Weiterverarbeitung erfasst wird. Die Anzahl von Umladungsvorgängen ist bei der in Fig. 2a) dargestellten Kurve als N gewählt, wobei N die Pulszahl ist, an welcher die Spannung einen Bruchteil von 1-1/e ihres Maximalwerts erreicht hat ohne Beeinflussung der Sensorelektrode, was in dem Ausführungsbeispiel als Arbeitspunkt gewählt wird. Nach Erreichen des Arbeitspunkts und dem Erfassen des Werts $A_1$ wird ein weiterer Umladungszyklus durchgeführt. Der weitere, in Fig. 2b) dargestellte, Umladungszyklus wird mit einer abweichenden Zahl von Umladungsvorgängen durchgeführt, nämlich mit N-1 Umladungsvorgängen. Die Anzahl der Pulse ist derart gewählt, dass nach einer Anzahl von N Umladungszyklen ein Anteil von 1-1/e der Gesamtladung erreicht wäre; jedoch wird die Anzahl von Umladungsvorgängen abweichend zu N-1 gewählt, das heißt, nach bereits N-1 Umladungszyklen wird ein ADC-Wert, in diesem Fall die am Ladekondensator abfallende Spannung, als Parameter $A_2$ erfasst. Das Aufladen wird somit mit einer Anzahl von Umladungsvorgängen durchgeführt, welche um 1 geringer ist als die der beim ersten Umladungszyklus durchgeführten Umladungsvorgänge.

Die erfassten Parameter $A_1$ und $A_2$ liegen bei der dargestellten Ausführungsform jeweils als 10-Bit-Werte vor. Durch Addition der 10-Bit-Werte sowie zusätzlicher Addition des Werts 1 im untersten Bit ($A_{sum} = A_1 + A_2 +1$) wird erreicht, dass sowohl $A_{sum,1}$ als auch $B_{sum,1}$ als 11-Bit-Werte vorliegen.

## Patentansprüche

1.  Verfahren zum Auswerten von Kapazitätswerten einer kapazitiven Sensorelektrode, aufweisend die folgenden Schritte:

    a) Koppeln der Sensorelektrode mit einem Ladeschaltkreis zum Aufladen der Sensorelektrode mit Ladungsträgern unter einer vorgegebenen Ladespannung,
    b) Entkoppeln der Sensorelektrode von dem Ladeschaltkreis und Koppeln der Sensorelektrode mit einem Speicherschaltkreis, der eine Speicherkapazität $C_L$ aufweist, zum Umladen von in der Sensorelektrode gespeicherten Ladungsträgern zu der Speicherkapazität $C_L$ hin,
    wobei die Schritte a) und b) für einen Umladungszyklus eine vorgegebene Anzahl von Umladungsvorgängen $n_{U,i}$ durchgeführt werden, wobei $n_{U,i}$ eine positive ganze Zahl ist und i ein Laufparameter, zum sukzessive Aufladen der Speicherkapazität, wobei vor einem erneuten Koppeln der Sensorelektrode mit dem Ladeschaltkreis jeweils ein Entkoppeln der Sensorelektrode von dem Speicherschaltkreis erfolgt,
    c) Erfassen eines von der Kapazität der Sensorelektrode abhängigen Parameters $A_i$ als ADC-Wert, mit i: Laufindex, nach Abschluss des Umladungszyklus,
    wobei wenigstens zwei Umladungszyklen durchgeführt und jeweils zugehörige Parameter $A_i$ erfasst werden,
    wobei $n_{U,i}$ und $n_{U,i+1}$ derart vorgegeben und auf den Arbeitspunkt zur Erfassung der Parameter $A_i$ und $A_{i+1}$ angepasst sind, dass bei unveränderter Kapazität der Sensorelektrode ein Summenwert aus $A_i$ und $A_{i+1}$ und/oder ein Differenzwert aus $A_i$ und $A_{i+1}$ am Arbeitspunkt genau zwischen zwei Bits einer ADC-Ausgabe liegt oder von dem Zwischenwert zwischen zwei Bits einer ADC-Ausgabe um höchstens einen Maximalwert abweicht,
    wobei ein Gesamtwert $A_{ges}$ unter Nutzung der Parameter $A_1$ aus einem ersten Umladungszyklus und $A_2$ aus einem zweiten Umladungszyklus gebildet wird,
    wobei die Anzahl der Umladungsvorgänge $n_{U,i}$ zwischen dem ersten Umladungszyklus und dem zweiten Umladungszyklus um wenigstens die Anzahl 1 voneinander abweicht,
    wobei der Kapazitätswert der Sensorelektrode unter Nutzung des Gesamtwerts $A_{ges}$ ausgewertet wird.

2.  Verfahren zum Auswerten von Kapazitätswerten einer kapazitiven Sensorelektrode, aufweisend die folgenden Schritte:

    a) Koppeln einer Speicherkapazität $C_L$ eines Speicherschaltkreises mit einem Ladeschaltkreis zum Aufladen der Speicherkapazität mit Ladungsträgern unter einer vorgegebenen Ladespannung, nachfolgend Entkoppeln der Speicherkapazität von dem Ladeschaltkreis,
    b) Koppeln des Speicherschaltkreises mit der Sensorelektrode, zum Umladen von in der Speicherkapazität gespeicherten Ladungsträgern zu der Sensorelektrode hin,
    c) Entkoppeln der Sensorelektrode von dem Speicherschaltkreis und Entladen der Sensorelektrode,
    wobei Schritte b) und c) für einen Umladungszyklus eine vorgegebene Anzahl von Umladungsvorgängen $n_{U,i}$ durchgeführt werden zum sukzessive Entladen der Speicherkapazität,
    d) Erfassen eines von der Kapazität der Sensorelektrode abhängigen Parameters $A_i$ als ADC-Wert, mit i: Laufindex, nach Abschluss des Umladungszyklus,
    wobei wenigstens zwei Umladungszyklen durchgeführt und jeweils zugehörige Parameter $A_i$ erfasst werden,
    wobei ein Gesamtwert $A_{ges}$ unter Nutzung von Parametern $A_1$ aus einem ersten Umladungszyklus und $A_2$ aus einem zweiten Umladungszyklus gebildet wird,
    wobei die Anzahl der Umladungsvorgänge $n_{U,i}$ zwischen dem ersten Umladungszyklus und dem zweiten Umladungszyklus um wenigstens die Anzahl 1 voneinander abweicht,
    wobei $n_{U,i}$ und $n_{U,i+1}$ derart vorgegeben und auf den Arbeitspunkt zur Erfassung der Parameter $A_i$ und $A_{i+1}$ angepasst sind, dass bei unveränderter Kapazität der Sensorelektrode ein Summenwert aus $A_i$ und $A_{i+1}$ und/oder ein Differenzwert aus $A_i$ und $A_{i+1}$ am Arbeitspunkt genau zwischen zwei Bits einer ADC-Ausgabe liegt oder von dem Zwischenwert zwischen zwei Bits einer ADC-Ausgabe um höchstens einen Maximalwert abweicht, wobei der Kapazitätswert der Sensorelektrode unter Nutzung des Gesamtwerts $A_{ges}$ ausgewertet wird.

3. Verfahren nach Anspruch 1 oder nach Anspruch 2, **dadurch gekennzeichnet, dass** die Anzahl $n_{U,i}$ zwischen dem ersten Umladungszyklus und dem zweiten Umladungszyklus um genau die Anzahl 1 voneinander abweichen.

4. Verfahren nach einem der vorhergehenden Ansprüche, **dadurch gekennzeichnet, dass** eine Folge von Umladungszyklen durchgeführt wird,

   wobei $n_{U,i}$ = N und $n_{U,i}$ = N-1
   bei allen unmittelbar aufeinander nachfolgenden Umladungszyklen alternieren.

5. Verfahren nach einem der vorhergehenden Ansprüche, **dadurch gekennzeichnet, dass**

$$A_{ges} \; = \; A_1 \; - \; A_2 \; + \; C$$

   ist, mit C als positiver oder negativer ganzer Zahl oder Null, zur Bereitstellung von $A_{ges}$ als ADC-Werte mit um gegenüber $A_1$, $A_2$ um einen Bit erhöhter Auflösung.

6. Verfahren nach Anspruch 5, **dadurch gekennzeichnet, dass** für $A_{ges,i}$ aus allen unmittelbar aufeinanderfolgenden i-ten und i+1-ten Umladungszyklen

$$A_{ges,i} \; = \; A_i \; - \; A_{(i+1)} \; + \; C$$

   ist.

7. Verfahren nach einem der vorhergehenden Ansprüche, **dadurch gekennzeichnet, dass** $A_i$ als 10-Bit-ADC-Werte erfasst werden.

8. Verfahren nach einem der vorhergehenden Ansprüche, **dadurch gekennzeichnet, dass** $n_{U,i}$ derart gewählt werden, dass für den ersten Umladungszyklus und den zweiten Umladungszyklus eine Abweichung

$$Abs(A_2^{dez} - A_1^{dez}) - 0,5 - D \; < \; Abw_{tol}$$

   mit einer tolerierten Maximalabweichung $Abw_{tol}$, wobei D ein ganzzahliger ADC-Offset ist.

9. Verfahren nach Anspruch 8, **dadurch gekennzeichnet, dass** die tolerierte Maximalabweichung $Abw_{tol}$ höchstens 0,10 Promille, bevorzugt höchstens 0,05 Promille, des Maximalwerts des ADC-Wandlers beträgt.

10. Kapazitive Annäherungssensoranordnung mit

   - einer Sensorelektrode,
   - einem Ladeschaltkreis, der mit einem ersten Schalter mit der Sensorelektrode koppelbar und entkoppelbar ist,
   - einem Speicherschaltkreis, der eine Speicherkapazität $C_L$ aufweist und mittels eines zweiten Schalters mit der Sensorelektrode koppelbar und entkoppelbar ist,
   - einen Analog-Digital-Umsetzer, kurz: ADC-Wandler,
   - und einem Mikrocontroller,

   wobei der Mikrocontroller eingerichtet ist, den ersten Schalter und den zweiten Schalter gemäß einem Verfahren nach einem der vorhergehenden Ansprüche anzusteuern.

**Claims**

1. Method for evaluating capacitance values of a capacitive sensor electrode, comprising the following steps:

a) Coupling the sensor electrode to a charging circuit to charge the sensor electrode with charge carriers under a predetermined charging voltage,

b) decoupling the sensor electrode from the charging circuit and coupling the sensor electrode to a storage circuit having a storage capacitance $C_L$ for recharging charge carriers stored in the sensor electrode towards the storage capacitance $C_L$,

wherein steps a) and b) are carried out for a recharging cycle with a predetermined number of recharging operations $n_{U,i}$, wherein $n_{U,i}$ is a positive integer and i is a running parameter, for successively charging the storage capacitance, wherein prior to a subsequent coupling of the sensor electrode to the charging circuit a respective decoupling of the sensor electrode from the storage circuit takes place,

c) acquisition of a parameter $A_i$ dependent on the capacitance of the sensor electrode as an ADC value, with i: running index, after completion of the recharging cycle,

wherein at least two recharging cycles are carried out and associated parameters $A_i$ are acquired in each case,

wherein $n_{U,i}$ and $n_{U,i+1}$ are predetermined and adapted to the operating point for detecting the parameters $A_i$ and $A_{i+1}$ in such a way that, with unchanged capacitance of the sensor electrode, a sum value of $A_i$ and $A_{i+1}$ and/or a difference value of $A_i$ and $A_{i+1}$ at the operating point lies exactly between two bits of an ADC output or deviates from the intermediate value between two bits of an ADC output by at most one maximum value,

wherein a total value $A_{ges}$ is determined using the parameters $A_1$ from a first recharging cycle and $A_2$ from a second recharging cycle,

wherein the number of recharging operations $n_{U,i}$ between the first recharging cycle and the second recharging cycle differs from each other by at least the number 1,

where the capacitance value of the sensor electrode is evaluated using the total value $A_{ges}$.

2. Method for evaluating capacitance values of a capacitive sensor electrode, comprising the following steps:

a) Coupling a storage capacitance $C_L$ of a storage circuit with a charging circuit for charging the storage capacitance with charge carriers under a predetermined charging voltage, subsequently decoupling the storage capacitance from the charging circuit,

b) coupling the storage circuit to the sensor electrode, to transfer charge carriers stored in the storage capacitance to the sensor electrode,

c) decoupling the sensor electrode from the storage circuit and discharging the sensor electrode,

wherein steps b) and c) are carried out for a recharging cycle with a predetermined number of recharging operations $n_{U,i}$, for successively discharging the storage capacitance,

d) acquisition of a parameter $A_i$ dependent on the capacitance of the sensor electrode as ADC value, with i: running index, after completion of the recharging cycle,

wherein at least two recharging cycles are carried out and associated parameters $A_i$ are acquired in each case,

wherein a total value $A_{ges}$ is determined using parameters $A_1$ from a first recharging cycle and $A_2$ from a second recharging cycle,

wherein the number of recharging operations $n_{U,i}$ between the first recharging cycle and the second recharging cycle differs from each other by at least the number 1,

wherein $n_{U,i}$ and $n_{U,i+1}$ are predetermined and adapted to the operating point for detecting the parameters $A_i$ and $A_{i+1}$ in such a way that, with unchanged capacitance of the sensor electrode, a sum value of $A_i$ and $A_{i+1}$ and/or a difference value of $A_i$ and $A_{i+1}$ at the operating point lies exactly between two bits of an ADC output or deviates from the intermediate value between two bits of an ADC output by at most one maximum value, wherein the capacitance value of the sensor electrode is evaluated using the total value $A_{ges}$.

3. Method according to claim 1 or according to claim 2, **characterised in that** the number $n_{U,i}$ between the first recharging cycle and the second recharging cycle differ from each other by exactly the number 1.

4. Method according to any one of the preceding claims, **characterised in that** a sequence of recharging cycles is carried out,

where $n_{U,i} = N$ and $n_{U,i} = N-1$
alternate for all immediately successive recharging cycles.

5. Method according to any one of the preceding claims, **characterised in that**

$$A_{ges} = A_1 - A_2 + C$$

with C as a positive or negative integer or zero, for providing $A_{ges}$ as ADC values with a resolution increased by one bit compared to $A_1$, $A_2$.

6. Method according to claim 5, **characterised in that** for $A_{ges,i}$ from all immediately successive i-th and i+1-th recharging cycles:

$$A_{ges,i} = A_i - A_{(i+1)} + C.$$

7. Method according to any of the preceding claims, **characterised in that** $A_i$ is acquired as 10-bit ADC values.

8. Method according to one of the preceding claims, **characterised in that** $n_{U,i}$ are chosen in such a way that for the first recharging cycle and the second recharging cycle a deviation of

$$Abs(A_2^{dez} - A_1^{dez}) - 0.5 - D < Abw_{tol}$$

with a tolerated maximum deviation $Abw_{tol}$, wherein D is an integer ADC offset.

9. Method according to claim 8, **characterised in that** the tolerated maximum deviation $Abw_{tol}$ is at most 0.10 per mil, preferably at most 0.05 per mil, of the maximum value of the ADC converter.

10. Capacitive proximity sensor arrangement with

   - of a sensor electrode,
   - a charging circuit which can be coupled and decoupled with a first switch to the sensor electrode,
   - a storage circuit which has a storage capacitance $C_L$ and can be coupled to and decoupled from the sensor electrode by means of a second switch,
   - an analogue-to-digital converter, or ADC converter for short,
   - and a microcontroller,

   wherein the microcontroller is arranged to control the first switch and the second switch according to a method according to any one of the preceding claims.

**Revendications**

1. Procédé d'évaluation des valeurs de capacité d'une électrode de capteur capacitif , comprenant les étapes suivantes :

   a) couplage de l'électrode de détection à un circuit de charge pour charger l'électrode de détection avec des porteurs de charge sous une tension de charge prédéterminée,
   b) découpler l'électrode de détection du circuit de charge et coupler l'électrode de détection à un circuit de stockage ayant une capacité de stockage $C_L$ pour transférer des porteurs de charge stockés dans l'électrode de détection vers la capacité de stockage $C_L$ ,
   les étapes a) et b) étant effectuées pour un cycle de recharge un nombre prédéterminé d'opérations de recharge $n_{U,i}$ , $n_{U,i}$ étant un nombre entier positif et i un paramètre d'exécution, pour charger successivement la capacité de stockage, un découplage de l'électrode de capteur du circuit de stockage étant effectué à chaque fois avant un nouveau couplage de l'électrode de capteur avec le circuit de charge ,
   c) saisie d'un paramètre $A_i$ dépendant de la capacité de l'électrode de détection comme valeur CAN, avec i : indice de marche, après achèvement du cycle de rechargement,

   au moins deux cycles de transbordement étant effectués et les paramètres correspondants $A_i$ étant res-

pectivement saisis,

$n_{U,i}$ et $n_{U,i+1}$ étant prédéfinis et adaptés au point de travail pour la saisie des paramètres $A_i$ et $A_{i+1}$ de telle sorte que, lorsque la capacité de l'électrode de détection n'est pas modifiée, une valeur de somme de $A_i$ et $A_{i+1}$ et/ou une valeur de différence de $A_i$ et $A_{i+1}$ se situe au point de travail exactement entre deux bits d'une sortie CAN ou s'écarte de la valeur intermédiaire entre deux bits d'une sortie CAN d'au plus une valeur maximale,

une valeur totale $A_{ges}$ étant formée en utilisant les paramètres $A_1$ d'un premier cycle de rechargement et $A_2$ d'un deuxième cycle de rechargement,

dans lequel le nombre d'opérations de transbordement $n_{U,i}$ entre le premier cycle de transbordement et le deuxième cycle de transbordement diffère d'au moins le nombre 1,

la valeur de capacité de l'électrode de détection étant évaluée en utilisant la valeur totale $A_{ges}$.

**2.** Procédé d'évaluation des valeurs de capacité d'une électrode de détection capacitive, comprenant les étapes suivantes :

a) couplage d'une capacité de mémoire $C_L$ d'un circuit de mémoire avec un circuit de charge pour charger la capacité de mémoire avec des porteurs de charge sous une tension de charge prédéterminée, puis découplage de la capacité de mémoire du circuit de charge,

b) coupler le circuit de stockage à l'électrode de détection, pour transférer des porteurs de charge stockés dans la capacité de stockage vers l'électrode de détection,

c) découpler l'électrode de détection du circuit de stockage et décharger l'électrode de détection,

dans lequel les étapes b) et c) pour un cycle de rechargement, un nombre prédéterminé d'opérations de rechargement $n_{U,i}$ sont effectuées pour décharger successivement la capacité de stockage,

d) l'enregistrement d'un paramètre $A_i$ dépendant de la capacité de l'électrode de détection en tant que valeur CAN, avec i : indice de marche, après l'achèvement du cycle de rechargement,

au moins deux cycles de transbordement étant effectués et les paramètres correspondants $A_i$ étant respectivement saisis,

une valeur totale $A_{ges}$ étant formée en utilisant des paramètres $A_1$ d'un premier cycle de rechargement et $A_2$ d'un deuxième cycle de rechargement,

dans lequel le nombre d'opérations de transbordement $n_{U,i}$ entre le premier cycle de transbordement et le deuxième cycle de transbordement diffère d'au moins le nombre 1,

$n_{U,i}$ et $n_{U,i+1}$ étant prédéfinis et adaptés au point de travail pour la saisie des paramètres $A_i$ et $A_{i+1}$ de telle sorte que, lorsque la capacité de l'électrode de détection n'est pas modifiée, une valeur de somme de $A_i$ et $A_{i+1}$ et/ou une valeur de différence de $A_i$ et $A_{i+1}$ se situe au point de travail exactement entre deux bits d'une sortie CAN ou s'écarte de la valeur intermédiaire entre deux bits d'une sortie CAN d'au plus une valeur maximale,

la valeur de capacité de l'électrode de détection étant évaluée en utilisant la valeur totale $A_{ges}$.

**3.** Procédé selon la revendication 1 ou selon la revendication 2, **caractérisé en ce que** le nombre $n_{U,i}$ entre le premier cycle de rechargement et le deuxième cycle de rechargement diffère exactement du nombre 1.

**4.** Procédé selon l'une quelconque des revendications précédentes, **caractérisé en ce qu'**il consiste à effectuer une succession de cycles de rechargement,

où $n_{U,i} = N$ et $n_{U,i} = N-1$
alternent pour tous les cycles de rechargement qui se suivent immédiatement.

**5.** Procédé selon l'une quelconque des revendications précédentes, **caractérisé en ce que**

$$A_{ges} = A_1 - A_2 + C$$

où C est un entier positif ou négatif ou zéro,
pour fournir $A_{ges}$ comme valeurs CAN avec une résolution augmentée d'un bit par rapport à $A_1$, $A_2$.

**6.** Procédé selon la revendication 5, **caractérisé en ce que** pour $A_{ges,i}$ de tous les i-èmes et i+1-èmes cycles de rechargement immédiatement successifs :

$$A_{ges,i} = A_i - A_{(i+1)} + C.$$

**7.** Procédé selon l'une quelconque des revendications précédentes, **caractérisé en ce que** $A_i$ est détecté en tant que valeurs CAN à 10 bits.

**8.** Procédé selon l'une quelconque des revendications précédentes, **caractérisé en ce que** $n_{U,i}$ sont choisis de telle sorte que, pour le premier cycle de rechargement et le second cycle de rechargement, un écart de

$$Abs(A_2^{dez} - A_1^{dez}) - 0,5 - D < Abw_{tol}$$

avec un écart maximal toléré $Abw_{tol}$ , où D est un décalage CAN entier.

**9.** Procédé selon la revendication 8, **caractérisé en ce que** l'écart maximal toléré $Abw_{tol}$ est au maximum de 0,10 pour mille, de préférence au maximum de 0,05 pour mille, de la valeur maximale du convertisseur CAN.

**10.** Agencement de capteurs de proximité capacitifs avec

- d'une électrode de détection,
- un circuit de charge qui peut être couplé et découplé de l'électrode de détection au moyen d'un premier commutateur,
- un circuit de mémoire, qui présente une capacité de mémoire $C_L$ et qui peut être couplé et découplé de l'électrode de détection au moyen d'un deuxième commutateur,
- un convertisseur analogique-numérique, en bref : un convertisseur CAN,
- et un microcontrôleur,

dans lequel le microcontrôleur est adapté pour commander le premier commutateur et le deuxième commutateur selon un procédé selon l'une quelconque des revendications précédentes.

Fig. 1

a)

b)

EP 3 763 042 B1

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19681725 B4
- DE 102013112910 A1
- DE 102014007236 A1
- DE 102015008485 A1